# EUROPEAN PATENT APPLICATION

(11) **EP 4 668 061 A1**
(43) Date of publication of application: **24.12.2025**
(21) Application number: 25183505.4
(22) Date of filing: 17.06.2025
(51) Int. Cl.: G06F 1/20, H01L 23/40, H05K 7/20

(54) **COMPUTING AND HEAT DISSIPATION INTEGRATED UNIT AND ELECTRONIC DEVICE**

(30) Priority: 18.06.2024 CN 202421394925 U
(71) Applicant: Bitdeer Semiconductor Technology PTE. LTD., 049514 Singapore (SG)
(72) Inventor: LI, Weiguo, 049514 Singapore (SG); YANG, Senfeng, 049514 Singapore (SG)
(74) Representative: Metida

(57) **Abstract**

Disclosure are a computing and heat dissipation integrated unit and an electronic device. The unit includes a first hash board and a heat dissipation assembly. A plurality of first ribs are juxtaposed on a first plate surface of the heat dissipation assembly. The first hash board includes a first substrate, a plurality of first chip strips are arranged on a first surface of the first substrate, and a number of the first chip strips is equal to a number of the first ribs. The first plate surface of the heat dissipation assembly and the first substrate are connected by at least two groups of first spring bolts. Two groups of the at least two groups of first spring bolts are respectively disposed in the first plate surface outside two outermost first ribs.

## Description

### TECHNICAL FIELD

The present disclosure relates to the technical field of liquid cooling, and in particular, relates to a computing and heat dissipation integrated unit, and an electronic device.

### BACKGROUND

To meet the ever-increasing demands from consumers for higher computing power in electronic computing devices, a solution has emerged wherein a plurality of hash boards are integrated into a single electronic computing device to obtain an electronic device with high computing power. Furthermore, to timely dissipate the significant heat generated when these hash boards operate, heat dissipation elements are connected to these hash boards to enable sufficient and rapid heat exchange with these hash boards via the heat dissipation elements.

Current methods for connecting heat dissipation elements with hash boards typically require high manufacturing precision for both components. However, the degree of close contact between the heat dissipation elements and the hash boards is often relatively low, and thus it is inconvenient to manufacture and use. Therefore, the heat dissipation effect is in urgent need of further improvement.

### SUMMARY

In view of the aforementioned situation, the present disclosure is mainly intended to provide a computing and heat dissipation integrated unit and an electronic device, which are capable of achieving the technical effect of relaxing the manufacturing precision requirements for the heat dissipation assembly and effectively improving the uniformity and tightness of contact between a heat dissipation assembly and a hash board.

In a first aspect, embodiments of the present disclosure provide a computing and heat dissipation integrated unit. The computing and heat dissipation integrated unit includes a first hash board and a heat dissipation assembly, wherein main bodies of the first hash board and the heat dissipation assembly are both plate-shaped; wherein the heat dissipation assembly has a first plate surface and a second plate surface that are disposed facing away from each other, a plurality of first ribs being juxtaposed on the first plate surface, wherein the first ribs protrude from the first plate surface beyond regions thereof where no first ribs are arranged, the first ribs are spaced from edge regions of at least two opposite first edges of the first plate surface, and the two first edges are respectively disposed outside two outermost first ribs of the plurality of first ribs; the first hash board includes a first substrate, a plurality of first chip strips being arranged on a surface of the first substrate, wherein each of the first chip strips includes a plurality of chips, a number of the first chip strips is equal to a number of the first ribs, the first chip strips are spaced from edge regions of at least two opposite second edges of the surface of the first substrate where the first chip strips are disposed, and the two second edges are respectively disposed outside two outermost first chip strips of the plurality of first chip strips; the first hash board is mounted on the first plate surface of the heat dissipation assembly, wherein the plurality of first ribs are in contact with the plurality of first chip strips in one-to-one correspondence; at least two groups of first plate-surface bolt holes are arranged in the first plate surface of the heat dissipation assembly, and the first plate surface and the first substrate are connected by at least two groups of first spring bolts, wherein two groups of the at least two groups of first spring bolts are respectively disposed in the first plate surface outside the two outermost first ribs, and each group of the two groups of first spring bolts is inserted into a corresponding group of first plate-surface bolt holes; and a spring of each of the first spring bolts is pressed against a surface of the first substrate where no first chip strips are arranged.

In some embodiments, a number of the first ribs is a multiple of N, where N>1; starting from a first one of the first ribs closest to one of the first edges of the first plate surface, every N consecutive adjacent first ribs constitute a first rib group; and on the first plate surface of the heat dissipation assembly, a group of first spring bolts is arranged in a portion between each pair of two adjacent first rib groups, at a position corresponding to the first hash board.

In some embodiments, all groups of the first plate-surface bolt holes have a same number of bolt holes; and a total number of chips in each of the first chip strips is greater than or equal to M, where M is a predetermined value; and a number of first plate-surface bolt holes in each group of the at least two groups of first plate-surface bolt holes is L, where (1/3)M≥L≥(1/5)M.

In some embodiments, the heat dissipation assembly is a liquid cooling assembly and includes a top cover portion and a flow channel portion, wherein main bodies of the top cover portion and the flow channel portion are both plate-shaped; wherein the flow channel portion, the top cover portion, and the first hash board are arranged sequentially; the first plate surface of the heat dissipation assembly is a surface of the top cover portion facing the first hash board, and the second plate surface of the heat dissipation assembly is a surface of the flow channel portion facing away from the top cover portion; and the flow channel portion has a first surface, wherein the first surface is a surface thereof facing towards the top cover portion; and a first hash board through-hole is arranged at a position on the first hash board corresponding to a mounting position of each of the first spring bolts, a top cover through-hole is provided at a corresponding position on the top cover portion, and a flow channel threaded hole is arranged at a corresponding position on the first surface of the flow channel portion, wherein the each of the first spring bolts runs through the first hash board through-hole and the top cover through-hole at the mounting position thereof and is screwed into the flow channel threaded hole.

In some embodiments, the flow channel portion is provided with a protruding end corresponding to each of the flow channel threaded holes, wherein the protruding end protrudes from the first surface of the flow channel portion, the flow channel threaded hole is arranged in the protruding end, the top cover through-hole is correspondingly insert-fitted with the protruding end, and the protruding end does not extend beyond a surface of the top cover portion that faces away from the flow channel portion.

In some embodiments, a thermally conductive material layer is arranged between each of the first ribs and the chips of a corresponding first chip strip.

In some embodiments, the unit further includes a second hash board, wherein a main body of the second hash board is plate-shaped; wherein a plurality of second ribs are juxtaposed on the second plate surface of the heat dissipation assembly, wherein the second ribs protrude from the second plate surface beyond regions thereof where no second ribs are arranged, the second ribs are spaced from edge regions of at least two opposite third edges of the second plate surface, and the two third edges are respectively disposed outside two outermost second ribs of the plurality of second ribs; the second hash board includes a second substrate, a plurality of second chip strips being arranged on a surface of the second substrate, wherein each of the second chip strips comprises a plurality of chips, a number of the second chip strips is equal to a number of the second ribs, the second chip strips are spaced from edge regions of at least two opposite fourth edges of the surface of the second substrate where the second chip strips are disposed, and the two fourth edges are respectively disposed outside two outermost second chip strips of the plurality of second chip strips; the second hash board is mounted on the second plate surface of the heat dissipation assembly, wherein the plurality of second ribs are in contact with the plurality of second chip strips in one-to-one correspondence; the second plate surface of the heat dissipation assembly and the second substrate are connected by at least two groups of second spring bolts, wherein two groups of the second spring bolts of the at least two groups of second spring bolts are respectively disposed on the second plate surface outside two outermost second ribs of the plurality of second ribs; and a spring of each of the second spring bolts is pressed against a surface of the second substrate where no second chip strips are arranged.

In some embodiments, a number of the second ribs is equal to a number of the first ribs, wherein a mounting position of each of the second ribs corresponds to a mounting position of one of the first ribs.

In some embodiments, a manner in which the second plate surface is in contact with the second hash board is in correspondence with a manner in which the first plate surface is in contact with the first hash board; wherein the correspondence of the manners means that a number of groups of the first spring bolts is equal to a number of groups of the second spring bolts, a mounting position of each group of the first spring bolts corresponds to a mounting position of one group of the second spring bolts, and within corresponding groups of the first spring bolts and the second spring bolts having corresponding mounting positions, a number of the first spring bolts is equal to a number of the second spring bolts, and a mounting position of each of the first spring bolts corresponds to a mounting position of one of the second spring bolts.

In a second aspect, embodiments of the present disclosure provide an electronic device. The electronic device includes the computing and heat dissipation integrated unit as described above.

In the present disclosure, a plurality of first ribs are provided on the first plate surface of the heat dissipation assembly. By causing the plurality of first ribs to be in contact with a plurality of first chip strips on the first hash board in one-to-one correspondence, and by utilizing a plurality of groups of first spring bolts to adjust and enhance the degree of contact between the heat dissipation assembly and the first hash board, with the springs of the first spring bolts pressing on the first hash board, a structural configuration that is simple and facilitates manufacturing and control of processing precision is achieved. This structural configuration fully ensures the uniformity and tightness of contact between the heat dissipation assembly and the first hash board. Additionally, the tightness of contact between the heat dissipation assembly and the first hash board can also be flexibly adjusted.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic perspective structural view of a computing and heat dissipation integrated unit according to some embodiments of the present disclosure;
FIG. 2 is a schematic perspective structural view of a computing and heat dissipation integrated unit with a first hash board removed according to some embodiments of the present disclosure;
FIG. 3 is a schematic perspective structural view of a first hash board according to some embodiments of the present disclosure;
FIG. 4 is a schematic perspective structural view of a top cover portion according to some embodiments of the present disclosure;
FIG. 5 is a schematic perspective structural view of a flow channel portion according to some embodiments of the present disclosure;
FIG. 6 is a schematic perspective structural view of a computing and heat dissipation integrated unit according to some embodiments of the present disclosure; and
FIG. 7 is a front sectional view of the perspective structure in FIG. 6.

Reference numerals and denotations thereof:

| | | | | | |
|---|---|---|---|---|---|
| 100 | Heat dissipation assembly | 131 | Top cover through-hole | 212 | Second edge |
| 110 | First plate surface | 140 | Flow channel portion | 213 | First hash board through-hole |
| 111 | First rib | 141 | First surface | 300 | Second hash board |
| 112 | First rib group | 142 | Flow channel threaded hole | 400 | Group of first spring bolts |
| 113 | First edge | 143 | Protruding end | 401 | First spring bolt |
| 120 | Second plat surface | 200 | First hash board | 500 | Group of second spring bolts |
| 121 | Second rib | 210 | First substrate | 501 | Second spring bolt |
| 130 | Top cover portion | 211 | First chip strip | 600 | Thermally conductive material layer |

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

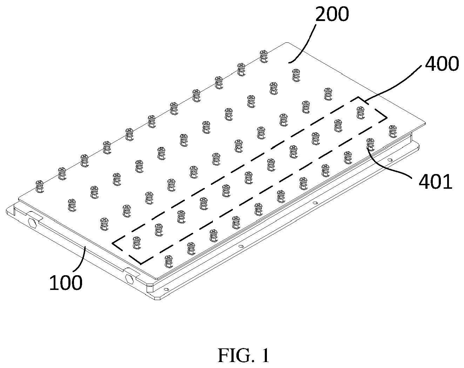

Referring to FIG. 1 to FIG. 7, some embodiments of the present disclosure provide a computing and heat dissipation integrated unit. The computing and heat dissipation integrated unit includes a first hash board 200 and a heat dissipation assembly 100. Main bodies of the first hash board 200 and the heat dissipation assembly 100 are both plate-shaped.

The heat dissipation assembly 100 has a first plate surface 110 and a second plate surface 120 that are disposed facing away from each other. A plurality of first ribs 111 are juxtaposed on the first plate surface 110. The first ribs 111 protrude from the first plate surface 110 beyond regions thereof where no first ribs are arranged. The first ribs 111 are spaced from edge regions of at least two opposite first edges 113 of the first plate surface 110. The two first edges 113 are respectively disposed outside two outermost first ribs 111 of the plurality of first ribs 111.

The first hash board 200 includes a first substrate (210). A plurality of first chip strips 211 are arranged on a surface of the first substrate (210). Each of the first chip strips 211 includes a plurality of chips. A number of the first chip strips 211 is equal to a number of the first ribs 111. The first chip strips 211 are spaced from edge regions of at least two opposite second edges 212 of the surface of the first substrate 210 where the first chip strips are disposed. The two second edges 212 are respectively disposed outside two outermost first chip strips 211 of the plurality of first chip strips 211.

The first hash board 200 is mounted on the first plate surface 110 of the heat dissipation assembly 100, wherein the plurality of first ribs 111 are in contact with the plurality of first chip strips 211 in one-to-one correspondence.

At least two groups of first plate-surface bolt holes are arranged in the first plate surface 110 of the heat dissipation assembly 100. The first plate surface 110 and the first substrate 210 are connected by at least two groups of first spring bolts 401. Two groups of the at least two groups of first spring bolts 401 are respectively disposed in the first plate surface 110 outside the two outermost first ribs 111. Each group of the two groups of first spring bolts is inserted into a corresponding group of first plate-surface bolt holes.

A spring of each of the first spring bolts 401 is pressed against a surface of the first substrate 210 where no first chip strips 211 are arranged.

Specifically, in the computing and heat dissipation integrated unit according to the present disclosure, the heat dissipation assembly 100 is employed to dissipate heat from the first hash board 200, which is (thermal) contact with the first hash board 200. The first hash board 200 provides high-speed computing capabilities by being equipped with a plurality of first chip strips 211, with each of the first chip strips 211 including a plurality of chips. Accompanying the high-speed computing capabilities is a large amount of heat generated when these chips operate. A primary objective of the present disclosure is to enable the heat dissipation assembly 100 to be in close contact with the first chip strips 211 by designing a structural configuration that is simple and facilitates manufacturing and processing, thereby timely conducting and exchanging the heat generated when these first chip strips 211 operate.

To this end, in the present disclosure, a plurality of first ribs 111 are arranged on the first plate surface 110 of the heat dissipation assembly 100, such that the first ribs 111 protrude from regions of the first plate surface 110 where no first ribs are provided, and are spaced from edge regions of at least two opposite first edges 113 of the first plate surface 110. Consequently, these first ribs 111 may be made to be in contact with the plurality of first chip strips 211 on the first hash board 200 in one-to-one correspondence. By means of the these first ribs 111, it is convenient to ensure the surface flatness at the contact interface between the heat dissipation assembly and the chip strips of the hash board (it is only necessary to ensure a high surface flatness of these ribs, without no need of a high surface flatness for the entire first plate surface, and hence processing difficulty is effectively reduced and production efficiency is significantly improved). In this way, the tightness of contact between the heat dissipation assembly and the chip strips is increased.

Furthermore, because on the first plate surface 110 of the heat dissipation assembly 100, the edge regions of at least two opposite first edges 113 are spaced apart by the first ribs 111, and thus a mounting space is reserved for mounting members (the first spring bolts 401 in the present disclosure) between the heat dissipation assembly 100 and the first substrate 210 of the first hash board 200. Apparently, on the first substrate 210 of the first hash board 200, the configuration that the first chip strips 211 are spaced from the edge regions of the two opposite second edges 212 of the plate surface on which the first chip strips 211 are disposed also reserves a mounting space for the first spring bolts 401.

It may be understood by those skilled in the art that, according to actual needs, the mounting space may be even larger and does not need to be limited only to the edge regions of the two opposite first edges 113 (and the two opposite second edges 212), but at least these edge regions need to be reserved. Therefore, in practical applications, taking the first plate surface 110 of the heat dissipation assembly 100 as an example, it is sufficient to arrange two of the at least two groups of first spring bolts respectively outside the two outermost first ribs 111 on the first plate surface 110 (for example, when viewing the first plate surface 110 from above, if the plurality of first ribs 111 are juxtaposed in a left-right direction, then one of these two groups of first spring bolts is arranged outside a leftmost first rib 111, and the other group is arranged outside a rightmost first rib 111). The spaces on the first plate surface 110 respectively outside the two outermost first ribs 111 (extending all the way to the first edges 113) constitute the mounting space for these two groups of first spring bolts. The first spring bolts are not necessarily limited to the two groups arranged outside the two outermost first ribs 111 on the first plate surface 110; rather, there may be more groups of first spring bolts (in FIG. 1, one such first spring bolt group 400 is indicated by a dashed box for illustrative purposes).

Therefore, the first plate surface 110 of the heat dissipation assembly 100 and the first substrate 210 of the first hash board 200 are connected by at least two groups of first spring bolts. In addition to the two groups of first spring bolts distributed at the outermost positions, there may also be groups of first spring bolts arranged between one first rib 111 and an adjacent first rib 111 of the first ribs 111, such that more than two groups of first spring bolts all exert a pressing force on the contact between the heat dissipation assembly 100 and the first hash board 200. This, in conjunction with the arrangement where the spring of each first spring bolt 401 is pressed against the surface of the first substrate 210 where no first chip strips are disposed, further improves the uniformity and tightness of contact between the heat dissipation assembly 100 and the first hash board 200. Moreover, the tightness of contact may also be flexibly adjusted by the degree of tightening of the first spring bolts 401.

It is apparent that the structural configuration of the computing and heat dissipation integrated unit according to the present disclosure is simple and facilitates manufacturing, is also conducive to controlling processing precision, and fully ensures the uniformity and tightness of contact between the heat dissipation assembly 100 and the first hash board 200, so as to fully ensure the heat conduction effect for the first hash board 200. Additionally, the tightness of contact between the heat dissipation assembly 100 and the first hash board 200 may also be flexibly adjusted according to the needs of actual use effects.

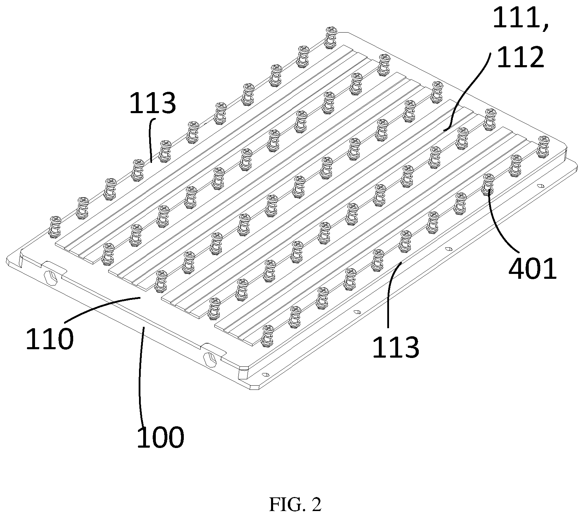

In some embodiments, particularly referring to FIG. 2, a number of the first ribs 111 is a multiple of N, where N>1; starting from a first one of the first ribs 111 closest to one of the first edges 113 of the first plate surface 110, every N consecutive adjacent first ribs constitute a first rib group 112; and on the first plate surface 110 of the heat dissipation assembly 100, a group of first spring bolts is arranged in a portion between each pair of two adjacent first rib groups, at a position corresponding to the first hash board 200.

Through the above-described rational spacing and distribution of the plurality of groups of first spring bolts, the first spring bolts 401 are not excessively distributed, and no material waste is caused. This is also conducive to making the pressure exerted by the plurality of groups of first spring bolts on the plurality of first chip strips 211 sufficient and as uniform as possible, such that the uniform heat dissipation effect for the first hash board 200 is further enhanced.

The value of N may be flexibly selected according to actual needs. In a specific embodiment, N may take a value of 3.

In some embodiments, all groups of the first plate-surface bolt holes have a same number of bolt holes.

A total number of chips in each of the first chip strips 211 is greater than or equal to M, where M is a predetermined value; and a number of first plate-surface bolt holes in each group of the at least two groups of first plate-surface bolt holes is L, where (1/3)M≥L≥(1/5)M.Generally, the total numbers of chips in the first chip strips 211 may not necessarily be exactly the same, but none has few chips. To help ensure that the number of first spring bolts 401 may also be sufficiently large, large enough to provide a sufficient and as uniform as possible pressing force to these chips, the number of first plate-surface bolt holes in each group of the at least two groups of first plate-surface bolt holes is thus made L, where (1/3)M≥L≥(1/5)M, and M is a predetermined value (in a specific implementation, M may be the total number of chips included in the one of all the first chip strips 211 that contains the fewest chips). In this way, by ensuring that there are a sufficient number of first plate-surface bolt holes, it may be ensured that a sufficient number of first spring bolts may be inserted therein to provide a pressing force to the chips. Nevertheless, it is not necessary in all cases to match and insert the first spring bolts into all the first plate-surface bolt holes. Instead, the number of first spring bolts used may be flexibly adjusted according to actual needs, such as a required pressing force on the chips, ease of assembly, or the like. That is, when the number of first spring bolts in each group is defined as P, the number P satisfies P≤L.

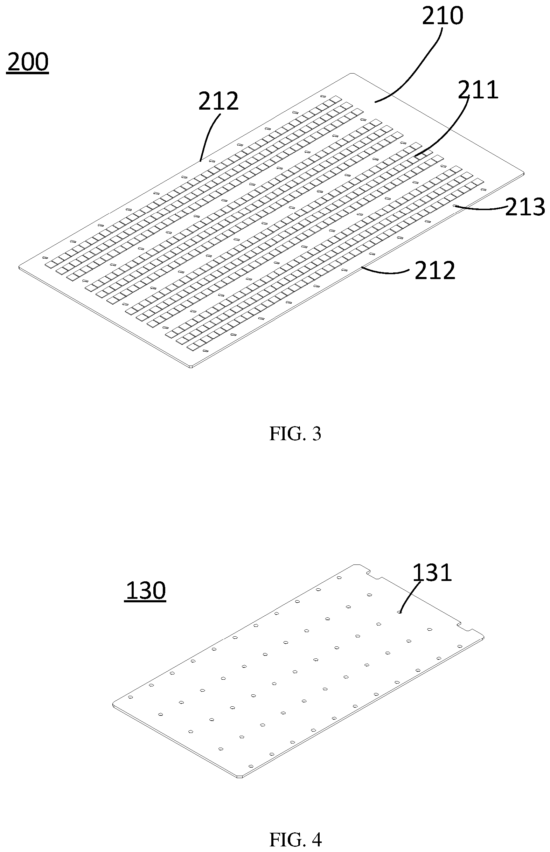

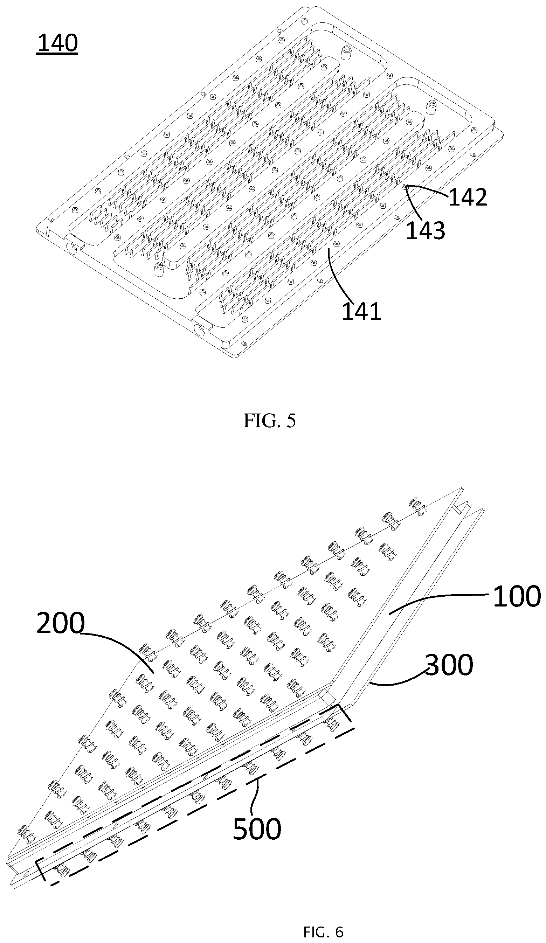

In some embodiments, referring to FIG. 4 and FIG. 5, the heat dissipation assembly 100 is a liquid cooling assembly and includes a top cover portion 130 and a flow channel portion 140. Main bodies of the top cover portion 130 and the flow channel portion 140 are both plate-shaped.

The flow channel portion 140, the top cover portion 130, and the first hash board 200 are arranged sequentially. The first plate surface 110 of the heat dissipation assembly 100 is a surface of the top cover portion 130 facing the first hash board 200, and the second plate surface 120 of the heat dissipation assembly 100 is a surface of the flow channel portion 140 facing away from the top cover portion 130. The flow channel portion 140 has a first surface 141, wherein the first surface 141 is a surface thereof facing towards the top cover portion 130.

A first hash board through-hole 213 is arranged at a position on the first hash board 200 corresponding to a mounting position of each of the first spring bolts 401. A top cover through-hole 131 is provided at a corresponding position on the top cover portion 130. A flow channel threaded hole 142 is arranged at a corresponding position on the first surface 141 of the flow channel portion 140. The each of the first spring bolts 401 runs through the first hash board through-hole 213 and the top cover through-hole 131 at the mounting position thereof and is screwed into the flow channel threaded hole 142.

The computing and heat dissipation integrated unit according to the present disclosure is suitable for liquid cooling applications where a coolant is used to carry away heat from the hash board. This allows the first hash board 200 to be disposed over the top cover portion 130 of the liquid cooling heat dissipation assembly, and the flow channel portion 140 to be disposed below the top cover portion 130. The coolant may flow within flow channels inside the flow channel portion 140, and exchange the coolant with the heat originating from the first hash board 200 and transferred through the liquid cooling heat dissipation assembly into the flow channel portions, thereby achieving heat dissipation.

In this case, by respectively arranging the first hash board through-hole 213, the top cover through-hole 131, and the flow channel threaded hole 142 at corresponding positions on the relevant components, the first spring bolts 401 may be accommodated and mounted by a simple structural configuration, such that the first hash board 200 is securely mounted onto the heat dissipation assembly 100. The firmness of assembly between the top cover portion 130 and the flow channel portion 140 may be fully ensured by welding.

In some embodiments, particularly referring to FIG. 5, the flow channel portion 140 is provided with a protruding end 143 corresponding to each of the flow channel threaded holes 142. The protruding end 143 protrudes from the first surface 141 of the flow channel portion 140. The flow channel threaded hole 142 is arranged in the protruding end 143. The top cover through-hole 131 is correspondingly insert-fitted with the protruding end 143. The protruding end 143 does not extend beyond a surface of the top cover portion 130 that faces away from the flow channel portion 140.

By configuration of the protruding end 143, the top cover through-hole 131 may be correspondingly insert-fitted with the protruding end 143, which facilitates the rapid positioning of the top cover portion 130 at a suitable position on the flow channel portion 140. A height of the protruding end 143 is not greater than a thickness of the top cover portion 130. In this way, upon completion of assembly of the first hash board and the heat dissipation assembly, the protruding end 143 does not extend beyond the surface of the top cover portion 130 that faces away from the flow channel portion 140. This ensures that the protruding end 143 is not so high as to push up the first hash board 200, which would cause the chip strips 211 to be unable to be in close contact with the first ribs 111 on the first plate surface 110.

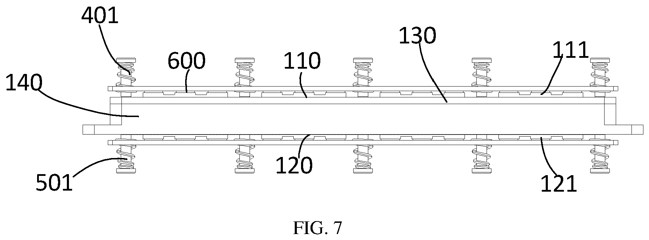

In some embodiments, particularly referring to FIG. 7, a thermally conductive material layer 600 is arranged between each of the first ribs 111 and the chips of a corresponding first chip strip 211.

The thermally conductive material layer arranged between the chip and the first ribs 111 effectively fills a minute gap between the chip and the first rib 111. Compared to a situation where no material layer is filled in the minute gap and air is present in the gap, it is apparent that in the present disclosure, by providing the thermally conductive material layer 600 here, the rapid and full conduction of heat from the chips is facilitated, such that the heat dissipation effect is further enhanced for the computing and heat dissipation integrated unit. The thermally conductive material layer 600 is, for example, a thermal grease layer, a gel layer, a thermal pad, or the like.

In some embodiments, particularly referring to FIG. 6 and FIG. 7, the unit further includes a second hash board 300. A main body of the second hash board 300 is plate-shaped.

A plurality of second ribs 121 are juxtaposed on the second plate surface 120 of the heat dissipation assembly 100. The second ribs 121 protrude from the second plate surface 120 beyond regions thereof where no second ribs are arranged. The second ribs 121 are spaced from edge regions of at least two opposite third edges 113 of the second plate surface 110. The two third edges 113 are respectively disposed outside two outermost second ribs 121 of the plurality of second ribs 121.

The second hash board 300 includes a second substrate. A plurality of second chip strips are arranged on a surface of the second substrate. Each of the second chip strips includes a plurality of chips. A number of the second chip strips is equal to a number of the second ribs 121. The second chip strips are spaced from edge regions of at least two opposite fourth edges of the surface of the second substrate where the second chip strips are disposed. The two fourth edges are respectively disposed outside two outermost second chip strips of the plurality of second chip strips.

The second hash board 300 is mounted on the second plate surface 120 of the heat dissipation assembly 100. The plurality of second ribs 121 are in contact with the plurality of second chip strips 211 in one-to-one correspondence.

The second plate surface 120 of the heat dissipation assembly 100 and the second substrate are connected by at least two groups of second spring bolts (in FIG. 6, one such second spring bolt group 500 is indicated by a dashed box for illustrative purposes). Two groups of the second spring bolts of the at least two groups of second spring bolts are respectively disposed on the second plate surface outside two outermost second ribs 121 of the plurality of second ribs 121.

A spring of each of the second spring bolts 501 is pressed against a surface of the second substrate where no second chip strips are arranged.

Essentially, contact-based assembly of the second plate surface 120 of the heat dissipation assembly 100 and the second hash board 300 is the same as that between that of the first plate surface 110 and the first hash board 200. Similarly, a structural configuration that is simple and facilitates manufacturing and control of processing precision is achieved, the uniformity and tightness of contact between the heat dissipation assembly and the hash board is fully ensured, and the tightness of contact between the heat dissipation assembly and the hash board is allowed to be flexibly adjusted.

In this case, the main structural configurations of the second hash board 300 and the first hash board 200 (including the configuration or arrangement of the chip strips, or the like) may also be the same.

In some embodiments, particularly referring to FIG. 7, a number of the second ribs 121 is equal to a number of the first ribs 111, wherein a mounting position of each of the second ribs 121 corresponds to a mounting position of one of the first ribs 111.

The "correspondence of mounting positions" means that each of the second ribs 121 and one of the first ribs 111 are arranged symmetrically with respect to each other, separated by the main body of the heat dissipation assembly 100.

In some embodiments, a manner in which the second plate surface 120 is in contact with the second hash board 300 is in correspondence with a manner in which the first plate surface 110 is in contact with the first hash board 200. The correspondence of the manners means that a number of groups of the first spring bolts 401 is equal to a number of groups of the second spring bolts 501, a mounting position of each group of the first spring bolts corresponds to a mounting position of one group of the second spring bolts, and within corresponding groups of the first spring bolts and the second spring bolts having corresponding mounting positions, a number of the first spring bolts 401 is equal to a number of the second spring bolts 501, and a mounting position of each of the first spring bolts 401 corresponds to a mounting position of one of the second spring bolts 501.

By the configuration corresponding to the manner described above, the pre-design of mounting positions for the plurality of groups of first spring bolts and the plurality of groups of second spring bolts, as well as the actual mounting operations, may be carried out more conveniently and quickly. The comprehensive pressing forces respectively supplied to the first hash board 200 and the second hash board 300 may also be made as equal and balanced as possible.

In this case, the flow channel threaded hole 142 may be a through-hole extending through an entire height direction of the flow channel portion 140. Within the same through-hole, one first spring bolt 401 may be inserted, and one second spring bolt 501 may also be inserted in an opposite direction.

Some embodiments of the present disclosure provide an electronic device. The electronic device includes the computing and heat dissipation integrated unit as described above.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A computing and heat dissipation integrated unit, comprising: a first hash board (200) and a heat dissipation assembly (100), wherein main bodies of the first hash board (200) and the heat dissipation assembly (100) are both plate-shaped; wherein
the heat dissipation assembly (100) has a first plate surface (110) and a second plate surface (120) that are disposed facing away from each other, a plurality of first ribs (111) being juxtaposed on the first plate surface (110), wherein the first ribs (111) protrude from the first plate surface (110) beyond regions thereof where no first ribs are arranged, the first ribs (111) are spaced from edge regions of at least two opposite first edges (113) of the first plate surface (110), and the two first edges (113) are respectively disposed outside two outermost first ribs (111) of the plurality of first ribs (111);
the first hash board (200) comprises a first substrate (210), a plurality of first chip strips (211) being arranged on a surface of the first substrate (210), wherein each of the first chip strips (211) comprises a plurality of chips, a number of the first chip strips (211) is equal to a number of the first ribs (111), the first chip strips (211) are spaced from edge regions of at least two opposite second edges (212) of the surface of the first substrate (210) where the first chip strips are disposed, and the two second edges (212) are respectively disposed outside two outermost first chip strips (211) of the plurality of first chip strips (211);
the first hash board (200) is mounted on the first plate surface (110) of the heat dissipation assembly (100), wherein the plurality of first ribs (111) are in contact with the plurality of first chip strips (211) in one-to-one correspondence;
at least two groups of first plate-surface bolt holes are arranged in the first plate surface (110) of the heat dissipation assembly (100), and the first plate surface (110) and the first substrate (210) are connected by at least two groups of first spring bolts (401), wherein two groups of the at least two groups of first spring bolts (401) are respectively disposed in the first plate surface (110) outside the two outermost first ribs (111), and each group of the two groups of first spring bolts is inserted into a corresponding group of first plate-surface bolt holes; and
a spring of each of the first spring bolts (401) is pressed against a surface of the first substrate (210) where no first chip strips are arranged.

2. The unit according to claim 1, wherein a number of the first ribs (111) is a multiple of N, where N>1; starting from a first one of the first ribs (111) closest to one of the first edges of the first plate surface (110), every N consecutive adjacent first ribs (111) constitute a first rib group (112); and on the first plate surface (110) of the heat dissipation assembly (100), a group of first spring bolts is arranged in a portion between each pair of two adjacent first rib groups (112), at a position corresponding to the first hash board (200).

3. The unit according to claim 1, wherein all groups of the first plate-surface bolt holes have a same number of bolt holes; and
a total number of chips in each of the first chip strips (211) is greater than or equal to M, where M is a predetermined value; and a number of first plate-surface bolt holes in each group of the at least two groups of first plate-surface bolt holes is L, where (1/3)M≥L≥(1/5)M.

4. The unit according to claim 1, wherein the heat dissipation assembly (100) is a liquid cooling assembly and comprises a top cover portion (130) and a flow channel portion (140), wherein main bodies of the top cover portion (130) and the flow channel portion (140) are both plate-shaped; wherein
the flow channel portion (140), the top cover portion (130), and the first hash board (200) are arranged sequentially; the first plate surface (110) of the heat dissipation assembly (100) is a surface of the top cover portion (130) facing the first hash board (200), and the second plate surface (120) of the heat dissipation assembly (100) is a surface of the flow channel portion (140) facing away from the top cover portion (130); and the flow channel portion (140) has a first surface (141), wherein the first surface (141) is a surface thereof facing towards the top cover portion (130);
a first hash board through-hole (213) is arranged at a position on the first hash board (200) corresponding to a mounting position of each of the first spring bolts (401), a top cover through-hole (131) is provided at a corresponding position on the top cover portion (130), and a flow channel threaded hole (142) is arranged at a corresponding position on the first surface (141) of the flow channel portion (140), wherein the each of the first spring bolts (401) runs through the first hash board through-hole (213) and the top cover through-hole (131) at the mounting position thereof and is screwed into the flow channel threaded hole (142).

5. The unit according to claim 4, wherein the flow channel portion (140) is provided with a protruding end (143) corresponding to each of the flow channel threaded holes (142), wherein the protruding end (143) protrudes from the first surface (141) of the flow channel portion (140), the flow channel threaded hole (142) is arranged in the protruding end (143), the top cover through-hole (131) is correspondingly insert-fitted with the protruding end (143), and the protruding end (143) does not extend beyond a surface of the top cover portion (130) that faces away from the flow channel portion (140).

6. The unit according to claim 1, wherein a thermally conductive material layer (600) is arranged between each of the first ribs (111) and the chips of a corresponding first chip strip (211).

7. The unit according to any one of claims 1 to 6, further comprising: a second hash board (300), wherein a main body of the second hash board (300) is plate-shaped; wherein
a plurality of second ribs (121) are juxtaposed on the second plate surface (120) of the heat dissipation assembly (100), wherein the second ribs (121) protrude from the second plate surface (120) beyond regions thereof where no second ribs are arranged, the second ribs (121) are spaced from edge regions of at least two opposite third edges (113) of the second plate surface (110), and the two third edges (113) are respectively disposed outside two outermost second ribs (121) of the plurality of second ribs (111);
the second hash board (300) comprises a second substrate, a plurality of second chip strips being arranged on a surface of the second substrate, wherein each of the second chip strips comprises a plurality of chips, a number of the second chip strips is equal to a number of the second ribs (121), the second chip strips are spaced from edge regions of at least two opposite fourth edges of the surface of the second substrate where the second chip strips are disposed, and the two fourth edges are respectively disposed outside two outermost second chip strips of the plurality of second chip strips;
the second hash board (300) is mounted on the second plate surface (120) of the heat dissipation assembly (100), wherein the plurality of second ribs (121) are in contact with the plurality of second chip strips (211) in one-to-one correspondence;
the second plate surface (120) of the heat dissipation assembly (100) and the second substrate are connected by at least two groups of second spring bolts, wherein two groups of the second spring bolts of the at least two groups of second spring bolts are respectively disposed on the second plate surface outside two outermost second ribs (121) of the plurality of second ribs (121); and
a spring of each of the second spring bolts (501) is pressed against a surface of the second substrate where no second chip strips are arranged.

8. The unit according to claim 7, wherein a number of the second ribs (121) is equal to a number of the first ribs (111), wherein a mounting position of each of the second ribs (121) corresponds to a mounting position of one of the first ribs (111).

9. The unit according to claim 8, wherein a manner in which the second plate surface (120) is in contact with the second hash board (300) is in correspondence with a manner in which the first plate surface (110) is in contact with the first hash board (200); wherein the correspondence of the manners means that a number of groups of the first spring bolts (401) is equal to a number of groups of the second spring bolts (501), a mounting position of each group of the first spring bolts corresponds to a mounting position of one group of the second spring bolts, and within corresponding groups of the first spring bolts and the second spring bolts having corresponding mounting positions, a number of the first spring bolts (401) is equal to a number of the second spring bolts (501), and a mounting position of each of the first spring bolts (401) corresponds to a mounting position of one of the second spring bolts (501).

10. An electronic device, comprising: the computing and heat dissipation integrated unit as defined in any one of claims 1 to 9.
